# EUROPEAN PATENT SPECIFICATION

(11) **EP 4 298 271 B1**
(45) Date of publication and mention of the grant of the patent: **10.12.2025**
(21) Application number: 22707300.4
(22) Date of filing: 11.02.2022
(51) Int. Cl.: C30B 15/00, C30B 29/06

(54) **METHODS FOR SELECTING THE LENGTHS OF LOWER AND UPPER EXHAUST TUBE PORTIONS OF AN INGOT PULLER APPARATUS**
VERFAHREN ZUR AUSWAHL DER LÄNGEN DER UNTEREN UND OBEREN ABGASROHRABSCHNITTE EINER INGOTZIEHVORRICHTUNG
PROCÉDÉS DE SÉLECTION DES LONGUEURS DE PARTIES DE TUBE D'ÉCHAPPEMENT INFÉRIEURE ET SUPÉRIEURE D'UN APPAREIL DE TIRAGE DE LINGOT

(30) Priority: 24.02.2021 US 202163153012 P
(43) Date of publication of application: 03.01.2024
(73) Proprietor: GlobalWafers Co., Ltd., Hsinchu (TW)
(72) Inventor: RYU, JaeWoo, St. Peters, Missouri 63376 (US); JI, JunHwan, St. Peters, Missouri 63376 (US); YUN, WooJin, St. Peters, Missouri 63376 (US); MEYER, Benjamin Michael, St. Peters, Missouri 63376 (US); HUDSON, Carissima Marie, St. Peters, Missouri 63376 (US)
(74) Representative: Maiwald GmbH
(86) International application number: PCT/US2022/016188
(87) International publication number: WO 2022/182534

(56) References cited:
- CN-A- 102 312 284
- CN-U- 204 752 905
- JP-A- 2002 316 896
- KIRPO MAKSIMS ED - AKIMOTO KATSUHIRO ET AL: "Global simulation of the Czochralski silicon crystal growth in ANSYS FLUENT", JOURNAL OF CRYSTAL GROWTH, ELSEVIER, AMSTERDAM, NL, vol. 371, 14 February 2013 (2013-02-14), pages 60 - 69, XP028546765, ISSN: 0022-0248, DOI: 10.1016/J.JCRYSGRO.2013.02.005

## Description

### FIELD OF THE INVENTION

The field of the invention relates to methods for selecting the length of the lower and upper portions of a compound exhaust tube of an ingot puller apparatus.

### BACKGROUND

Single crystal silicon ingots may be prepared by the so-called Czochralski method in which a single crystal silicon seed is contacted with a silicon melt held within a crucible. The single crystal silicon seed is withdrawn from the melt to pull the single crystal silicon ingot from the melt. The ingot may be prepared in a batch system in which a charge of polycrystalline silicon is initially melted within the crucible and the silicon ingot is withdrawn from the melt until the melted silicon within the crucible is depleted. Alternatively, the ingot may be withdrawn in a continuous Czochralski method in which polysilicon is intermittently or continuously added to the melt to replenish the silicon melt during ingot growth.

Crystal pulling may be performed in the presence of an atmosphere within a housing of the ingot puller apparatus. In both batch and continuous Czochralski processes, a process gas inert relative to silicon such as argon is continually introduced into the housing and withdrawn through an exhaust system of the puller. As the process gas is withdrawn, compounds may deposit on the exhaust system tubes (e.g., silicon carbide and silicon oxide compounds) which is at a lower temperature compared to the puller chamber. Such deposits are periodically removed from the exhaust system which may require the ingot puller apparatus to be taken out of operation thereby increasing processing cost. It is difficult to increase the sizing of the exhaust system as there is a need to maintain pressure within the housing which is difficult to achieve with larger cross-section exhaust tubes.

A need exists for crystal pulling systems that are characterized by reduced formation of deposits on the exhaust system of the ingot puller apparatus and that can withstand the environment (e.g., temperature) of the ingot puller apparatus.

JP 2002 316896 A describes a single crystal manufacturing apparatus and manufacturing method to prevent the deposition of oxides in an air exit of a growth furnace. Said manufacturing apparatus is provided with a waste gas pipe extension member so as to communicate with an air exit disposed in the lower part of the growth furnace to exhaust the inert gas flowing in the growth furnace and is provided with a protective gas pipe so as to enclose this waste gas pipe extension member.

CN 102 312 284 A aims at providing a thermal field of a straight pulling silicon single crystal furnace with a plurality of exhaust pipelines uniformly and downward distributed. At least three exhaust pipelines for exhaust gas discharging are uniformly distributed on the circumference at the bottom of the thermal field, and each exhaust pipeline has the following structures: each exhaust pipeline comprises a transverse air duct, a vertical air duct, and a quartz tube, and the transverse air duct and the vertical air duct are graphite pieces; the transverse air duct and the vertical air duct which are connected at a right angle cooperate in a plane contact mode; the vertical air duct has a butt joint with the quartz tube, and the vertical air duct and the quartz tube cooperate in an annular boss mode; and the quartz tube and vent holes of the bottom board of the furnace cooperate in an annular boss mode.

CN 204 752 905 U describes an exhaust duct for a vertical pulling silicon single crystal stove exhaust system.

This section is intended to introduce the reader to various aspects of art that may be related to various aspects of the invention, which are described and/or claimed below. This discussion is believed to be helpful in providing the reader with background information to facilitate a better understanding of the various aspects of the present invention. Accordingly, it should be understood that these statements are to be read in this light, and not as admissions of prior art.

### SUMMARY

The present invention is directed to a method for selecting a length of a lower, metal portion of a compound exhaust tube of an ingot puller apparatus. The compound exhaust tube includes an upper portion made of a first material and a lower portion coupled to the upper portion. The lower portion is made of a second material that is a metal. The second material is different from the first material. The compound exhaust tube extends upward from a bottom of a housing and through an insulation layer. The compound exhaust tube has a length that extends between a lower end and an upper end of the exhaust tube, the lower portion of the exhaust tube having a lower end that corresponds to the lower end of the exhaust tube. The method includes determining a threshold temperature for the lower, metal portion of the exhaust tube. The radial position of the exhaust tube is determined. The axial temperature profile of the ingot puller apparatus is determined at the radial position of the exhaust tube during a meltdown phase of ingot growth. The axial temperature profile decreases from an upper portion of the insulation layer toward the housing bottom. A length of the lower, metal portion of the exhaust tube is selected such that an upper end of the lower, metal portion is at an axial position in which the temperature of the lower, metal portion is less than the threshold temperature during the meltdown phase of ingot growth. The length of the lower, metal portion of the exhaust tube extends from the lower end to the upper end of the lower, metal portion of the exhaust tube.

Various refinements exist of the features noted in relation to the above-mentioned present invention. Further features may also be incorporated in the above-mentioned present invention as well. These refinements and additional features may exist individually or in any combination. For instance, various features discussed below in relation to any of the illustrated embodiments of the present invention may be incorporated into the present invention, alone or in any combination.

### BRIEF DESCRIPTION OF THE DRAWINGS

FIG. 1 is a cross-section of an ingot puller apparatus having a charge of polycrystalline silicon therein during meltdown;
FIG. 2 is a cross-section of the ingot puller apparatus after meltdown and before silicon ingot growth;
FIG. 3 is a cross-section of the ingot puller apparatus during silicon ingot growth;
FIG. 4 is a perspective view of an exhaust tube of the ingot puller apparatus; and
FIG. 5 is an exploded view of the exhaust tube showing an upper portion and a lower portion thereof.

Corresponding reference characters indicate corresponding parts throughout the drawings.

### DETAILED DESCRIPTION

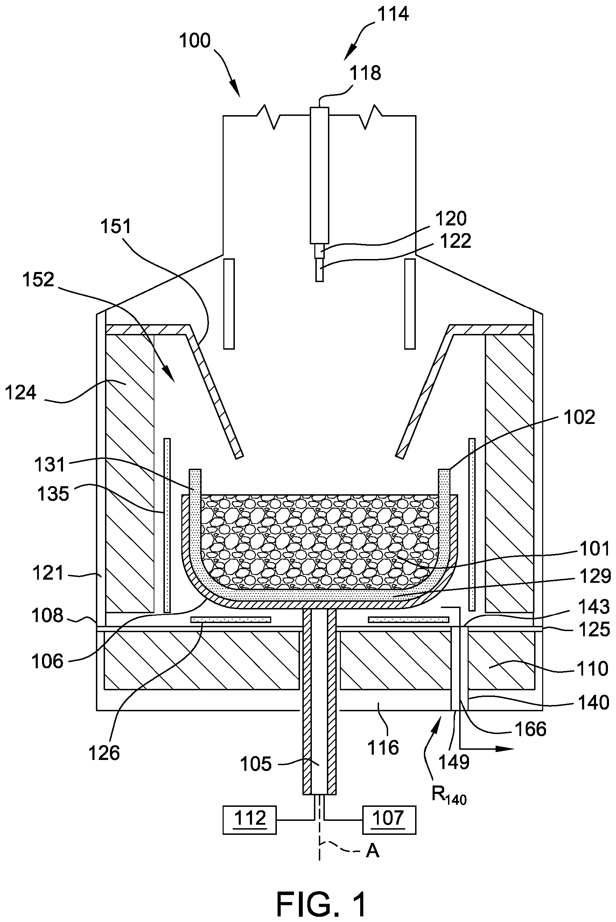

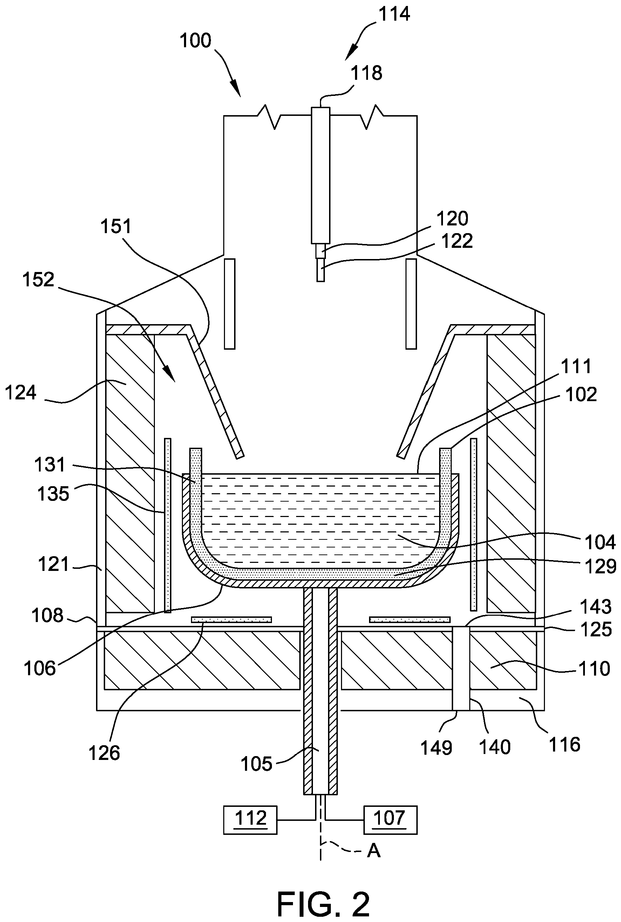

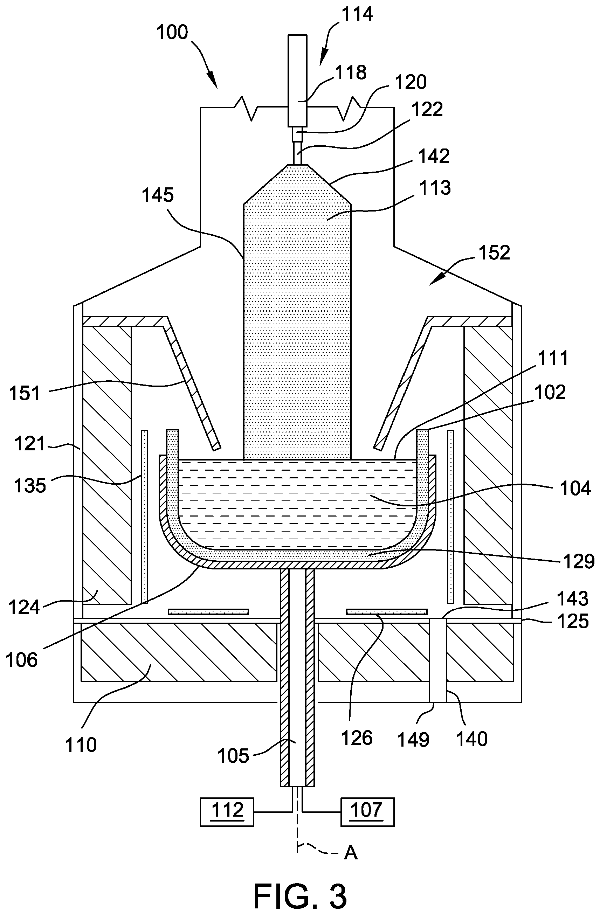

The present invention pertains to a method for selecting the length of a lower portion (i.e., metal lower portion) of the exhaust tube of an ingot puller apparatus. The method may generally be carried out in any ingot puller apparatus that is configured to pull a single crystal silicon ingot. An example ingot puller apparatus (or more simply "ingot puller") is indicated generally at "100" in FIG. 1. The ingot puller apparatus 100 includes a crucible 102 for holding a melt 104 (FIG. 2) of semiconductor or solar-grade material, such as silicon, supported by a susceptor 106. The ingot puller apparatus 100 includes an ingot puller housing 108 that defines a growth chamber 152 for pulling a silicon ingot 113 (Fig. 3) from the melt 104 along a pull axis A. The crucible 102 is disposed within the growth chamber 152. The ingot puller apparatus 100 is generally suited for batch Czochralski growth in which the ingot is grown fully from an initial charge 101 of polysilicon. In other embodiments, polysilicon is added during ingot growth as in a continuous Czochralski process.

The crucible 102 includes a floor 129 and a sidewall 131 that extends upward from the floor 129. The sidewall 131 is generally vertical. The floor 129 includes the curved portion of the crucible 102 that extends below the sidewall 131. Within the crucible 102 is a silicon melt 104 (FIG. 3) having a melt surface 111 (i.e., melt-ingot interface).

In some embodiments, the crucible 102 is layered. For example, the crucible 102 may be made of a quartz base layer and a synthetic quartz liner disposed on the quartz base layer.

The susceptor 106 is supported by a shaft 105. The susceptor 106, crucible 102, shaft 105 and ingot 113 (Fig. 3) have a common longitudinal axis A or "pull axis" A.

The ingot puller apparatus housing 108 includes a housing bottom 116 and a housing sidewall 121 that extends upward from the bottom 116. The ingot puller apparatus 100 includes an insulation bottom layer 110 that extends upward from the housing bottom 116. The ingot puller apparatus 100 includes an insulation cap 125 to prevent contaminants from entering the growth chamber 152 from the insulation bottom layer 110. Side insulation 124 extends radially inward from the housing sidewall 121.

A pulling mechanism 114 is provided within the ingot puller apparatus 100 for growing and pulling an ingot 113 (FIG. 3) from the melt 104. Pulling mechanism 114 includes a pulling cable 118, a seed holder or chuck 120 coupled to one end of the pulling cable 118, and a silicon seed crystal 122 coupled to the seed holder or chuck 120 for initiating crystal growth. One end of the pulling cable 118 is connected to a pulley (not shown) or a drum (not shown), or any other suitable type of lifting mechanism, for example, a shaft, and the other end is connected to the chuck 120 that holds the seed crystal 122. In operation, the seed crystal 122 is lowered to contact the melt 104. The pulling mechanism 114 is operated to cause the seed crystal 122 to rise. This causes a single crystal ingot 113 (FIG. 3) to be withdrawn from the melt 104.

During heating and crystal pulling, a crucible drive unit 107 (e.g., a motor) rotates the crucible 102 and susceptor 106. A lift mechanism 112 raises and lowers the crucible 102 along the pull axis A during the growth process. For example, as shown in FIG. 1, the crucible 102 may be at a lowest position (near the bottom heater 126) at which an initial charge 101 of solid-phase polycrystalline silicon previously added to the crucible 102 is melted. Crystal growth commences by contacting the melt 104 with the seed crystal 122 and lifting the seed crystal 122 by the pulling mechanism 114. As the ingot 113 grows, the silicon melt 104 is consumed and the height of the melt 104 in the crucible 102 decreases. The crucible 102 and susceptor 106 may be raised to maintain the melt surface 111 at or near the same position relative to the ingot puller apparatus 100 (FIG. 3).

A crystal drive unit (not shown) may also rotate the pulling cable 118 and ingot 113 (FIG. 3) in a direction opposite the direction in which the crucible drive unit 107 rotates the crucible 102 (e.g., counter-rotation). In embodiments using iso-rotation, the crystal drive unit may rotate the pulling cable 118 in the same direction in which crucible drive unit 107 rotates the crucible 102. In addition, the crystal drive unit raises and lowers the ingot 113 relative to the melt surface 111 as desired during the growth process.

The ingot puller apparatus 100 may include an inert gas system to introduce and withdraw an inert gas such as argon from the growth chamber 152. The ingot puller apparatus 100 may also include a dopant feed system (not shown) for introducing dopant into the melt 104.

According to the Czochralski single crystal growth process, a quantity of solid polycrystalline silicon 101 (FIG. 1), or polysilicon, is charged to the crucible 102. The initial charge 101 of semiconductor or solar-grade material that is introduced into the crucible 102 is melted by heat provided from one or more heating elements to form a silicon melt 104 (FIG. 2) in the crucible 102. The ingot puller apparatus 100 includes an insulation bottom layer 110 and side insulation 124 to retain heat in the growth chamber 152. A portion of the ingot puller apparatus 100 may be cooled (e.g., fluid cooled in a bottom portion of the apparatus 100). In the illustrated case, the ingot puller apparatus 100 includes a bottom heater 126 disposed below the crucible floor 129. As shown in FIG. 1, the crucible 102 may be moved to be in relatively close proximity to the bottom heater 126 to melt the polycrystalline charge 101 in the crucible 102.

To form the ingot 113 (FIG. 3), the seed crystal 122 is contacted with the surface 111 of the melt 104. The pulling mechanism 114 is operated to pull the seed crystal 122 from the melt 104. Referring now to FIG. 3, the ingot 113 includes a crown portion 142 in which the ingot 113 transitions and tapers outward from the seed crystal 122 to reach a target diameter. The ingot 113 includes a constant diameter portion 145 or cylindrical "main body" of the crystal 113 which is grown by increasing the pull rate. The main body 145 of the ingot 113 has a relatively constant diameter. The ingot 113 includes a tail or end-cone (not shown) in which the ingot tapers in diameter after the main body 145. When the diameter becomes small enough, the ingot 113 is then separated from the melt 104.

The ingot puller apparatus 100 includes a side heater 135 and a susceptor 106 that encircles the crucible 102 to maintain the temperature of the melt 104 during crystal growth. The side heater 135 is disposed radially outward to the crucible sidewall 131 as the crucible 102 travels up and down the pull axis A. The side heater 135 and bottom heater 126 may be any type of heater that allows the side heater 135 and bottom heater 126 to operate as described herein. In some cases, the heaters 135, 126 are resistance heaters. The side heater 135 and bottom heater 126 may be controlled by a control system (not shown) so that the temperature of the melt 104 is controlled throughout the pulling process. The bottom heater 126 and side heater 135 are exemplary and the ingot puller apparatus 100 may include different arrangements of heaters (e.g., heaters in different positions and/or additional heaters).

The ingot puller apparatus 100 may include a heat shield 151. The heat shield 151 may shroud the ingot 113 and may be partially disposed within the crucible 102 during crystal growth (FIG. 3).

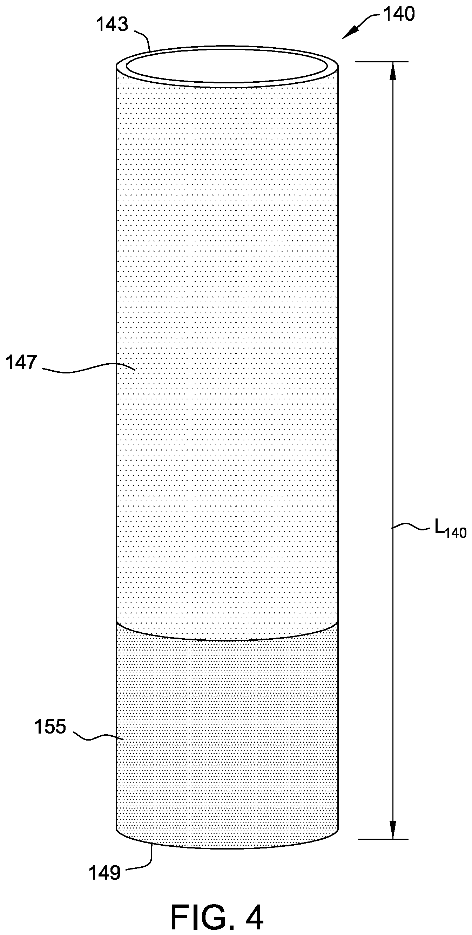

The ingot puller apparatus 100 includes an exhaust tube 140. The exhaust tube 140 extends through the bottom 116 of the housing 108, through the insulation bottom layer 110 and through the insulation cap 125 to the growth chamber 152. The exhaust tube 140 includes an upper end 143 which may be aligned with the insulation cap 125 and a lower end 149 aligned with the bottom 116 of the housing 108. The exhaust tube 140 has an overall length L₁₄₀ (FIG. 4) that extends from the upper end 143 to the lower end 149. The exhaust tube 140 defines an exhaust flow path 166 (FIG. 1) for discharging exhaust gas from the growth chamber 152. The exhaust tube 140 may be integrated into an exhaust port (not shown). The exhaust port may be connected to external conduits (e.g., by flanged connections) which direct the exhaust gas to a filtration system and a vacuum pump.

While the ingot puller apparatus 100 is shown with a single exhaust tube 140, it should be understood that the ingot puller apparatus 100 may include multiple exhaust tubes 140 (and associated exhaust ports) such as at least 2, 3, 4, 5, or 6 or more exhaust tubes 140. In such embodiments, each exhaust tube 140 may be a compound exhaust tube as described herein.

Referring now to FIG. 4, the exhaust tube 140 includes an upper portion 147 and a lower portion 155 coupled to the upper portion 147. The upper portion 147 is made of a first material and the lower portion 155 is made of a second material different from the first material. In accordance with some embodiments of the present invention, the first material of which the upper portion 147 is made has a melting temperature greater than the melting temperature of the second material of which the lower portion 155 is made. In some embodiments, the first material of which the upper portion 147 of the exhaust tube 140 is made is graphite. The second material of which the lower portion 155 of the exhaust tube 140 is made is a metal such as stainless steel (e.g., the upper portion 147 is graphite and the lower portion 155 is stainless steel).

It should be noted that the exhaust tube 140 shown in FIGS. 4-5 is exemplary. For example, the upper portion 147 and/or lower portion 155 may include two or more layers (e.g., the upper portion 147 may include a graphite layer on the inside and a metal layer on the outside). In some embodiments, the compound exhaust tube 140 includes additional portions made of different materials.

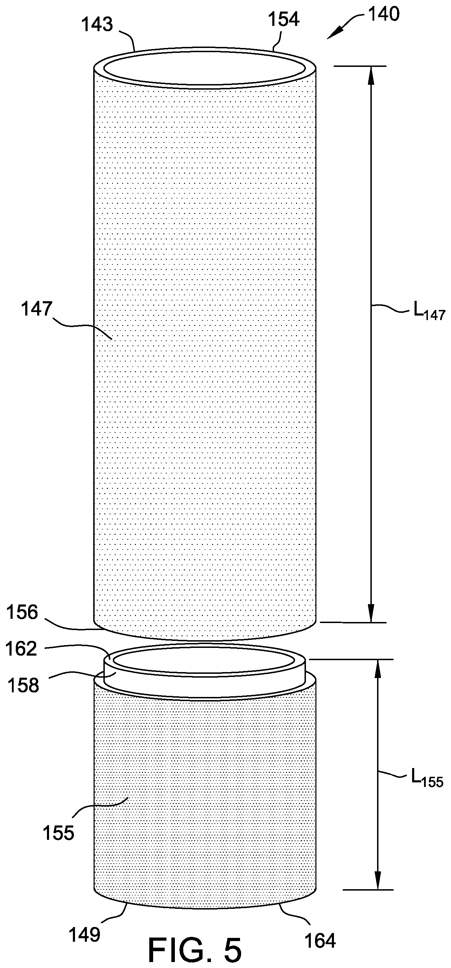

The upper portion 147 and lower portion 155 of the exhaust tube 140 may be coupled together according to any known methods for connecting two dissimilar materials. For example and as shown in FIG. 5, the lower portion 155 includes a collar 158. When the two portions 147, 155 are coupled together, the collar 158 is received in the upper portion 147 (e.g., within a counter bore formed in the upper portion 147). The collar 158 may be friction fit within the upper portion 147 (e.g., with the weight of the upper portion 147 and/or the bore within the insulation bottom layer 110 helping maintain the connection).

The upper portion 147 of the exhaust tube has a length L₁₄₇ that extends from its upper end 154 to its lower end 156. The lower portion 155 has a length L₁₅₅ that extends from its upper end 162 to its lower end 164 (i.e., the length L₁₅₅ includes the collar 158).

In accordance with the present invention, where the lower portion 155 of the exhaust tube 140 is metal such as stainless steel, and the length L₁₅₅ of the lower portion 155 of the exhaust tube 140 may be selected to prevent deformation and/or destruction of the lower portion 155 of the exhaust tube 140. To select the length L₁₅₅ of the lower portion 155 of the exhaust tube 140, a threshold temperature for the lower, metal portion 155 of the exhaust tube 140 is determined. The threshold temperature may be related to the melting temperature of the second material of the lower portion 155 of the exhaust tube 140 (e.g., 10°C less than the melting temperature of the second material of which the lower portion 155 of the exhaust tube 140 is made, or 25°C less than the melting temperature, 50°C less than the melting temperature, or 100°C less than the melting temperature of the second material of which the lower portion 155 of the exhaust tube 140 is made). In some embodiments, the threshold temperature is the melting temperature of the second material of the lower portion 155 of the exhaust tube 140.

In embodiments in which the lower portion 155 is made of stainless steel (e.g., 304L stainless steel which has a melting temperature generally ranging from 1400°C to 1420°C), the threshold temperature may be 1400°C or less, 1375°C or less, or 1330°C or less.

Embodiments of the method of selecting the length L₁₅₅ of the lower portion 155 of the exhaust tube 140 include determining the axial temperature profile of the ingot puller apparatus 100 at the radial position R₁₄₀ (FIG. 1) of the exhaust tube 140 during a meltdown phase of ingot growth (i.e., the temperature within the ingot puller apparatus along the length L₁₄₀ of the exhaust tube 140). In existing ingot pullers 100 in which the compound exhaust tube 140 is being retrofit for a conventional exhaust tube, the radial position R₁₄₀ (FIG. 1) of the exhaust tube 140 is simply the position of the tube in the ingot puller 100. In new ingot puller apparatus 100, the radial position R₁₄₀ is set by determining where the exhaust tube 140 will be positioned when designing new ingot puller apparatus 100.

The axial temperature profile at the radial position of the exhaust tube 140 may be determined by measuring temperatures within the ingot puller apparatus 100 during the meltdown phase of ingot growth (e.g., measuring actual temperatures within the ingot puller apparatus 100 with one or more temperature sensors). In some embodiments, the axial temperature profile at the radial position of the exhaust tube 140 is determined by modeling temperatures within the ingot puller apparatus 100 during the meltdown phase. The temperature profile of the ingot puller apparatus 100 during meltdown may be modeled by using commercially available tools, such as CrysVun (CrysVun software, Crystal Growth Laboratory, Fraunhofer Institute IISB, Erlangen, Germany), COMSOL (COMSOL multiphysics software, COMSOL Inc. Burlington, Massachusetts, USA), Fluent (commercial software managed by Ansys, Canonsburg, Pennsylvania, USA), and CGSim (CGSim software, commercialized by STR Group, Inc., St. Petersburg, Russia). These tools are exemplary and other software codes that model the heat transmission in a puller during meltdown (e.g., any steady-state 2D simulation) may be used.

In accordance the present invention, the temperature profile of the ingot puller apparatus 100 is determined during the meltdown phase in which the initial charge 101 (FIG. 1) of solid-phase polycrystalline silicon added to the crucible 102 is melted. During meltdown, the crucible 102 is typically lowered to its lowest position that is closest to the bottom heater (or heaters) 126. During meltdown, the exhaust tube 140 may be at its highest temperature and lower portion 155 being closest to the threshold temperature. The axial temperature profile at the radial position R₁₄₀ of the exhaust tube 140 generally decreases in temperature from its upper end 143 to its lower end 149.

Once the temperature profile of the ingot puller apparatus 100 at the radial position of the exhaust tube 140 is determined during the meltdown phase, a length L₁₅₅ of the lower, metal portion 155 of the exhaust tube 140 is selected. The length L₁₅₅ of the lower, metal portion 155 of the exhaust tube 140 is selected such that the upper end 162 (FIG. 5) of the lower, metal portion 155 is at an axial position in which the temperature of the entire lower, metal portion 155 is less than the threshold temperature during the meltdown phase of ingot growth (i.e., when melting the silicon charge 101 (FIG. 1)). In this regard, it should be noted that the length L₁₅₅ of the lower portion 155 of the exhaust tube may include the collar 158 (FIG. 5) to ensure that the entire lower portion 155 of the exhaust tube 140 is below the threshold temperature.

Because the length L₁₄₀ (FIG. 4) of the exhaust tube 140 is relatively fixed by the thickness of the insulation bottom layer 110, it should be noted that selecting the length L₁₅₅ of the lower portion 155 of the exhaust tube also sets the length L₁₄₇ of the upper portion 147 of the exhaust tube 140 (i.e., in embodiments in which the compound exhaust tube 140 only includes two sections and the height of the collar 158 is fixed).

In some embodiments, a second threshold temperature is set for the upper portion 147 of the exhaust tube 140 (i.e., with the threshold temperature described above being the first threshold temperature). In such embodiments, while the length L₁₅₅ of the lower portion 155 of the exhaust tube may be reduced to ensure that the upper end 162 of the lower portion 155 is less than the first threshold temperature, the length L₁₅₅ may also be selected such that the bottom portion 155 is sufficiently long to allow the entire length L₁₄₇ of the upper portion 147 of the exhaust tube 140 to be above the second threshold temperature. For example, the second threshold temperature may be the maximum temperature at which at least some deposits form on the upper portion 147 of the exhaust tube 140 (i.e., the second threshold temperature is a temperature at which such deposits do not form above the second threshold temperature). Example deposits include silicon oxides (SiOₓ), silicon (e.g., by silicon condensation), and silicon carbides (SiC) (including SiC and SiOₓ complexes). In embodiments in which the upper portion 147 is made of graphite, the second threshold temperature at which the upper portion 147 is maintained above (i.e., by making the lower portion 155 of sufficient length L₁₅₅ so as to keep the entire upper portion 147 at the hotter portions of the insulation bottom layer 110) may be 1200°C.

Compared to conventional ingot puller apparatus, the ingot puller apparatus described herein has several advantages. By using a compound exhaust tube, the exhaust tube may be tailored to reduce deposits which form in the exhaust tube. In embodiments in which the upper portion is made of graphite, the upper portion is relatively simpler and less expensive to fabricate. Graphite is also a relatively inexpensive material. In such embodiments, graphite is limited to the upper portion of the exhaust tube which is relatively higher in temperature and more resistant to formation of deposits. In embodiments in which the lower portion of the exhaust tube is made of stainless steel, stainless steel is resistant to formation of deposits which is beneficial at the cooler, lower portions of the exhaust tube at which deposits form more readily. By reducing deposits, the runtime of the ingot puller apparatus may be increased, which increases productivity. Longer run times allow for more consistent processing (which increases yield) and result in less frequent disassembly of the hot zone which reduces damage to the hot zone. Further, the exhaust tube may be replaced less often, thereby reducing operating cost. By modeling the temperature of the ingot puller apparatus, the length of the lower portion of the tube may be selected such that the upper end of the exhaust tube is below a threshold temperature at which the material of the lower portion (e.g., stainless steel) begins to deform or melt. Alternatively or in addition, the length of the lower portion of the tube may be selected such that the length of the upper portion of the tube is sufficiently short to ensure that the upper portion is above a temperature at which deposits form on the material from which the upper portion of the tube is made (e.g., above 1200°C for graphite).

### EXAMPLES

The processes of the present invention are further illustrated by the following Examples. These Examples should not be viewed in a limiting sense.

### Example 1: Use of a Compound Exhaust Tube

A compound exhaust tube was used in an ingot puller apparatus similar to the ingot puller apparatus 100 shown in FIGS. 1-3. The exhaust tube included an upper portion made of graphite and a lower portion made of stainless steel. During ingot growth, an upper section of the stainless steel lower portion of the exhaust tube melted. The temperature profile of the ingot puller apparatus was modeled using conventional tools. The boundary between the section of the stainless steel portion of the tube that melted and the section below it which did not melt generally corresponded to the position of the 1330°C contour line in the temperature profile of the ingot puller apparatus (i.e., the contour line at which the actual melting occurred may be used as a maximum threshold temperature for the lower, metal portion of the exhaust tube).

A second exhaust tube was used in the ingot puller apparatus that also included an upper portion made of graphite and a lower portion made of stainless steel. The length of the stainless steel lower portion of the second exhaust tube was reduced (and the length of the graphite upper portion correspondingly increased) such that the entire stainless steel portion was below the 1330°C contour line of the modeled temperature profile of the ingot puller apparatus. The stainless steel portion did not melt during ingot growth. The exhaust tube did not include excessive deposit formation of the upper graphite portion and the lower stainless portion included minimal deposits.

As used herein, the terms "about," "substantially," "essentially" and "approximately" when used in conjunction with ranges of dimensions, concentrations, temperatures or other physical or chemical properties or characteristics is meant to cover variations that may exist in the upper and/or lower limits of the ranges of the properties or characteristics, resulting from rounding, measurement methodology or other statistical variation.

When introducing elements of the present invention or the embodiment(s) thereof, the articles "a," "an," "the," and "said" are intended to mean that there are one or more of the elements. The terms "comprising," "including," "containing," and "having" are intended to be inclusive and mean that there may be additional elements other than the listed elements. The use of terms indicating a particular orientation (e.g., "top," "bottom," "side," etc.) is for convenience of description and does not require any particular orientation of the item described.

## Claims

1. A method for selecting a length of a lower, metal portion of a compound exhaust tube (140) of an ingot puller apparatus (100), the compound exhaust tube comprising an upper portion (147) made of a first material and a lower portion (155) coupled to the upper portion, the lower portion being made of a second material that is a metal, the second material being different from the first material, the compound exhaust tube extending upward from a bottom (116) of a housing (108) and through an insulation bottom layer (110), the compound exhaust tube having a length that extends between a lower end (149) and an upper end (143) of the exhaust tube, the lower portion of the exhaust tube having a lower end (164) that corresponds to the lower end of the exhaust tube, the method comprising:
determining a threshold temperature for the lower, metal portion of the exhaust tube;
determining the radial position of the exhaust tube;
determining the axial temperature profile of the ingot puller apparatus at the radial position of the exhaust tube during a meltdown phase of ingot growth, the axial temperature profile decreasing from an upper portion of the insulation layer toward the housing bottom; and
selecting a length of the lower, metal portion of the exhaust tube such that an upper end (162) of the lower, metal portion is at an axial position in which the temperature of the lower, metal portion is less than the threshold temperature during the meltdown phase of ingot growth, the length of the lower, metal portion of the exhaust tube extending from the lower end to the upper end of the lower, metal portion of the exhaust tube.

2. The method as set forth in claim 1 wherein the axial temperature profile at the radial position of the exhaust tube is determined by measuring temperatures within the ingot puller apparatus during the meltdown phase.

3. The method as set forth in claim 1 wherein the axial temperature profile at the radial position of the exhaust tube is determined by modeling temperatures within the ingot puller apparatus during the meltdown phase.

4. The method as set forth in any one of claims 1 to 3 wherein the threshold temperature is related to the melting temperature of the second material of the lower, metal portion of the exhaust tube.

5. The method as set forth in any one of claims 1 to 4 wherein the compound exhaust tube includes only two sections and wherein the threshold temperature is a first threshold temperature, the length of the lower, metal portion of the exhaust tube being selected such that the entire length of the upper portion of the exhaust tube is above a second threshold temperature, the second threshold temperature being a maximum temperature at which deposits form on the upper portion of the exhaust tube.

6. The method as set forth in claim 1 wherein the ingot puller apparatus comprises an insulation cap (125) that prevents contaminants from entering the growth chamber from the insulation bottom layer, the upper end of the exhaust tube being aligned with the insulation cap and the lower end of the exhaust tube being aligned with the bottom of the housing.

## Patentansprüche

1. Ein Verfahren zum Auswählen einer Länge eines unteren, metallischen Abschnitts eines Verbundabgasrohrs (140) einer Ingot-Ziehvorrichtung (100), wobei das Verbundabgasrohr einen oberen Abschnitt (147) aus einem ersten Material und einen mit dem oberen Abschnitt verbundenen unteren Abschnitt (155) umfasst, wobei der untere Abschnitt aus einem zweiten Material besteht, das ein Metall ist, wobei sich das zweite Material vom ersten Material unterscheidet, wobei sich das Verbundabgasrohr von einem Boden (116) eines Gehäuses (108) nach oben und durch eine isolierende Bodenschicht (110) erstreckt, wobei das Verbundabgasrohr eine Länge aufweist, die sich zwischen einem unteren Ende (149) und einem oberen Ende (143) des Abgasrohrs erstreckt, wobei der untere Abschnitt des Abgasrohrs ein unteres Ende (164) aufweist, das dem unteren Ende des Abgasrohrs entspricht, wobei das Verfahren umfasst:
Bestimmen einer Schwellentemperatur für den unteren, metallischen Abschnitt des Abgasrohrs;
Bestimmen der radialen Position des Abgasrohrs;
Bestimmen des axialen Temperaturprofils der Ingot-Ziehvorrichtung an der radialen Position des Abgasrohrs während einer Schmelzphase des Ingotwachstums, wobei das axiale Temperaturprofil von einem oberen Abschnitt der Isolierschicht zum Gehäuseboden hin abnimmt; und
Auswählen einer Länge des unteren, metallischen Abschnitts des Abgasrohrs, so dass sich ein oberes Ende (162) des unteren, metallischen Abschnitts an einer axialen Position befindet, an der die Temperatur des unteren, metallischen Abschnitts während der Schmelzphase des Ingotwachstums unter der Schwellentemperatur liegt, wobei sich die Länge des unteren, metallischen Abschnitts des Abgasrohrs vom unteren Ende zum oberen Ende des unteren, metallischen Abschnitts des Abgasrohrs erstreckt.

2. Das Verfahren gemäß Anspruch 1, wobei das axiale Temperaturprofil an der radialen Position des Abgasrohrs bestimmt wird durch Messung von Temperaturen innerhalb der Ingot-Ziehvorrichtung während der Schmelzphase.

3. Das Verfahren gemäß Anspruch 1, wobei das axiale Temperaturprofil an der radialen Position des Abgasrohrs bestimmt wird durch Modellieren von Temperaturen innerhalb der Ingot-Ziehvorrichtung während der Schmelzphase.

4. Das Verfahren gemäß irgendeinem der Ansprüche 1 bis 3, wobei die Schwellentemperatur mit der Schmelztemperatur des zweiten Materials des unteren, metallischen Abschnitts des Abgasrohrs zusammenhängt.

5. Das Verfahren gemäß irgendeinem der Ansprüche 1 bis 4, wobei das Verbundabgasrohr nur zwei Abschnitte umfasst, und wobei die Schwellentemperatur eine erste Schwellentemperatur ist, wobei die Länge des unteren, metallischen Abschnitts des Abgasrohrs so gewählt ist, das sich die gesamte Länge des oberen Anschnitts des Abgasrohrs oberhalb einer zweiten Schwellentemperatur befindet, wobei die zweite Schwellentemperatur eine Maximaltemperatur ist, bei der sich auf dem oberen Abschnitt des Abgasrohrs Ablagerungen bilden.

6. Das Verfahren gemäß Anspruch 1, wobei die Ingot-Ziehvorrichtung eine Isolierkappe (125) umfasst, die Verunreinigungen daran hindert, aus der isolierenden Bodenschicht in die Ziehkammer zu gelangen, wobei das obere Ende des Abgasrohrs an der Isolierkappe ausgerichtet ist und das untere Ende des Abgasrohrs am Gehäuseboden ausgerichtet ist.

## Revendications

1. Procédé de sélection d'une longueur d'une partie métallique inférieure d'un tube d'échappement composite (140) d'un appareil d'étirage de lingot (100), le tube d'échappement composite comportant une partie supérieure (147) constituée d'un premier matériau et une partie inférieure (155) couplée à la partie supérieure, la partie inférieure étant constituée d'un second matériau qui est un métal, le second matériau étant différent du premier matériau, le tube d'échappement composite s'étendant vers le haut à partir d'un fond (116) d'un boîtier (108) et à travers une couche inférieure d'isolation (110), le tube d'échappement composite ayant une longueur qui s'étend entre une extrémité inférieure (149) et une extrémité supérieure (143) du tube d'échappement, la partie inférieure du tube d'échappement ayant une extrémité inférieure (164) qui correspond à l'extrémité inférieure du tube d'échappement, le procédé comportant de :
déterminer une température de seuil pour la partie métallique inférieure du tube d'échappement,
déterminer la position radiale du tube d'échappement,
déterminer le profil de température axiale de l'appareil d'étirage de lingot à la position radiale du tube d'échappement pendant une phase de fusion de la croissance du lingot, le profil de température axiale diminuant d'une partie supérieure de la couche d'isolation vers le fond de boîtier, et
sélectionner une longueur de la partie métallique inférieure du tube d'échappement de telle sorte qu'une extrémité supérieure (162) de la partie métallique inférieure est à une position axiale dans laquelle la température de la partie métallique inférieure est inférieure à la température de seuil pendant la phase de fusion de la croissance du lingot, la longueur de la partie métallique inférieure du tube d'échappement s'étendant de l'extrémité inférieure à l'extrémité supérieure de la partie métallique inférieure du tube d'échappement.

2. Procédé selon la revendication 1, dans lequel le profil de température axiale à la position radiale du tube d'échappement est déterminé en mesurant des températures à l'intérieur de l'appareil d'étirage de lingot pendant la phase de fusion.

3. Procédé selon la revendication 1, dans lequel le profil de température axiale à la position radiale du tube d'échappement est déterminé en modélisant des températures à l'intérieur de l'appareil d'étirage de lingot pendant la phase de fusion.

4. Procédé selon l'une quelconque des revendications 1 à 3, dans lequel la température de seuil est liée à la température de fusion du second matériau de la partie métallique inférieure du tube d'échappement.

5. Procédé selon l'une quelconque des revendications 1 à 4, dans lequel le tube d'échappement composite comprend uniquement deux sections et dans lequel la température de seuil est une première température de seuil, la longueur de la partie métallique inférieure du tube d'échappement étant sélectionnée de telle sorte que la longueur complète de la partie supérieure du tube d'échappement est supérieure à une seconde température de seuil, la seconde température de seuil étant une température maximale à laquelle des dépôts se forment sur la partie supérieure du tube d'échappement.

6. Procédé selon la revendication 1, dans lequel l'appareil d'étirage de lingot comporte un couvercle d'isolation (125) qui empêche des contaminants d'entrer dans la chambre de croissance à partir de la couche inférieure d'isolation, l'extrémité supérieure du tube d'échappement étant alignée avec le couvercle d'isolation et l'extrémité inférieure du tube d'échappement étant alignée avec le fond du boîtier.
